(19) Europäisches Patentamt
European Patent Office
Office européen des brevets

(11) Veröffentlichungsnummer: **0 135 026 B1**

# (12) EUROPÄISCHE PATENTSCHRIFT

(45) Veröffentlichungstag der Patentschrift: **05.07.89**

(51) Int. Cl.⁴: **G 03 F 7/08**

(21) Anmeldenummer: **84108406.4**

(22) Anmeldetag: **17.07.84**

## (54) Lichthärtbares Gemisch und daraus hergestelltes lichtempfindliches Aufzeichnungsmaterial.

(30) Priorität: **25.08.83 US 525927**

(43) Veröffentlichungstag der Anmeldung: **27.03.85 Patentblatt 85/13**

(45) Bekanntmachung des Hinweises auf die Patenterteilung: **05.07.89 Patentblatt 89/27**

(84) Benannte Vertragsstaaten: **DE FR GB IT**

(56) Entgegenhaltungen:
**EP-A- 0 071 881**
**GB-A- 1 352 411**
**US-A- 2 980 534**
**US-A- 2 990 281**

(73) Patentinhaber: **HOECHST CELANESE CORPORATION, Route 202-206 North, Somerville, N.J. 08876 (US)**

(72) Erfinder: **Liu, Shuchen, 59 North Slope, Clinton New Jersey 08809 (US)**

(74) Vertreter: **Euler, Kurt Emil, Dr., HOECHST AG - Werk KALLE Patentabteilung Postfach 3540 Rheingaustrasse 190, D-6200 Wiesbaden (DE)**

EP 0 135 026 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft ein verbessertes lichthärtbares Gemisch sowie ein lichtempfindliches Aufzeichnungsmaterial, insbesondere für die Herstellung von Flachdruckplatten, das eine lichtempfindliche Schicht aus dem lichthärtbaren Gemisch enthält.

Bei den meisten lichtempfindlichen Aufzeichnungsmaterialien dieser Art besteht der Schichtträger aus einer Metallplatte, die mit einem lichtempfindlichen Diazoniumsalz-Polykondensationsprodukt im Gemisch mit geeigneten Bindemitteln, Farbstoffen, Pigmenten, Stabilisatoren, Belichtungsindikatoren, Netzmitteln und dergl. beschichtet ist.

Es ist eine Vielzahl für den Flachdruck geeigneter lichtempfindlicher Gemische bekannt, deren Verwendbarkeit jedoch dadurch eingeschränkt ist, dass die benötigten Entwicklerlösungen erhebliche Mengen an organischen Lösemitteln enthalten. Das ist unerwünscht, da diese Lösemittel teuer und im Abwasser umweltschädlich sind.

In der DE-A-1 447 957 (= GB-A-1 110 017) werden vorsensibilisierte Flachdruckplatten beschrieben, deren lichtempfindliche Schicht Kondensationsprodukte aus Diphenylamindiazoniumsalzen mit Formaldehyd in Kombination mit alkalilöslichen Harzen, z. B. Copolymeren aus Styrol und Maleinsäureanhydrid, enthält. Diese Schichten werden mit Wasser entwickelt, ergeben aber nur eine begrenzte Druckauflage.

In der DE-A-2 243 212 (= US-A-3 877 948) sind lithographische Druckplatten beschrieben, die aus wasserlöslichem Alkylenoxidpolymeren mit hohem Molekulargewicht, einem Polycarbonsäureharz oder einer Polycarbonsäure, die ein Assoziat mit dem Alkylenoxidpolymeren bildet, und einem photosensibilisierenden Mittel bestehen. Als Polycarbonsäureharze können in dieser lichtempfindlichen Mischung unter anderem auch Styrol-Maleinsäureanhydrid-Mischpolymerisate verwendet werden. Eine Entwicklung durch Auswaschen der unbelichteten Schichtbereiche erfolgt nicht. Auch hier ist die Druckauflage begrenzt, da naturgemäß die Hydrophilie der unbelichteten Hintergrundbereiche beim Lagern der Druckform am Licht allmählich verschwindet.

In der DE-A-2 019 426 (= GB-A-1 352 411) wird ein lichtempfindliches Gemisch und ein lichtempfindliches Kopiermaterial zur Herstellung ätzfester Schichten beschrieben. Als lichtempfindliche Substanzen werden Diazopolykondensate aus 4-Diazodiphenylaminen und kondensationsfähigen Verbindungen verwendet. Als polymeres Bindemittel wird ein Gemisch aus zwei Harzen beschrieben, von denen eines ein Styrol-Maleinsäureanhydrid-Copolymerisat, das andere ein Polyvinylacetat sein kann. Zur Entwicklung dieser Gemische dienen ausschließlich größere Mengen organische Lösemittel enthaltende Entwickler.

In der EP-A-48 876 (= US-A-4 387 151) ist ein lichtempfindliches Gemisch aus Diazoniumsalz-Mischkondensationsprodukten, die Diazoniumsalzeinheiten $A{-}N_2X$ und von Diazoniumgruppen freie Einheiten B enthalten, und einem in wäßrigem Alkali löslichen Polymeren mit seitenständigen Sulfonylurethangruppen vorgeschlagen worden. Dieses Gemisch läßt sich mit wäßrigen alkalischen Lösungen ohne Zusatz von organischen Lösemitteln entwickeln.

In der EP-A-71 881 ist ein lichtempfindliches Material für die Herstellung von Flachdruckplatten beschrieben, das in der lichtempfindlichen Schicht ein Diazoniumsalz-Mischkondensationsprodukt und ein Styrol/Maleinsäurepartialester-Mischpolymerisat enthält. Die Schicht läßt sich mit rein wäßrigen alkalischen Lösungen entwickeln. Diese Druckplatten liefern hohe Auflagen, jedoch sind sie nicht ausreichend resistent gegen alkalisches Feuchtwasser; auch ihre Farbannahme ist in manchen Fällen nicht optimal.

In der US-A-2 990 281 wird ein Diazotypiematerial beschrieben, das in der lichtempfindlichen Schicht neben Diazoniumverbindungen bestimmte harzartige Copolymere, z. B. solche aus Styrol und Maleinsäurepartialestern enthält. Die Schicht kann ggf. noch wasserunlösliche Polymere, z. B. Polyvinylacetat, enthalten. Das Material liefert farbige Bilder, ist aber zur Herstellung von Druckplatten nicht geeignet.

Aufgabe der Erfindung war es, ein Verfahren zur Herstellung von Flachdruckplatten aus einem negativ arbeitenden lichtempfindlichen Gemisch auf Basis von Diazoniumsalz-Polykondensationsprodukten vorzuschlagen, bei dem mit im wesentlichen wäßrigen Lösungen entwickelt werden kann und die erhaltenen Druckplatten hohe Druckauflagen liefern und beim Druck resistent gegen alkalische Feuchtwässer sind, eine gute Oleophilie aufweisen und nach dem Entwickeln keine Neigung zur Redeposition etwa unlöslich gebliebener Schichtbestandteile auf der Trägeroberfläche zeigen.

Erfindungsgemäß wird ein Verfahren zur Herstellung von Flachdruckplatten vorgeschlagen, bei dem man ein lichtempfindliches Aufzeichnungsmaterial, dessen lichtempfindliche Schicht als wesentliche Bestandteile

a) ein Diazoniumsalz-Polykondensationsprodukt,

b) ein Styrol/Maleinsäuremonoalkylester-Copolymerisat, in dem die Alkylgruppe 1 bis 5 Kohlenstoffatome hat und das ein mittleres Molekulargewicht von nicht mehr als 50 000 aufweist, und

c) ein Vinylacetatpolymerisat mit einem mittleren Molekulargewicht von 100 000 bis 800 000 enthält,

bildmäßig belichtet und durch Auswaschen der unbelichteten Schichtbereiche entwickelt.

Das erfindungsgemäße Verfahren ist dadurch gekennzeichnet, daß man als Entwickler eine wäßrig-alkalische Lösung einsetzt, die ein Natrium-, Kalium- oder Lithiumsalz des Monooctyl-, Monodecyl- oder Monododecylsulfats, ein Natrium-, Lithium-, Kalium- oder Ammoniumborat oder -metasilikat, eine aliphatische Dicarbonsäure mit 2 bis 6 Kohlenstoffatomen oder deren Natrium-, Kalium- oder Ammoniumsalz, ein Di- oder Trinatrium- oder ein Di- oder Trikaliumphosphat enthält.

Als wäßrig-alkalischer Entwickler ist ein Entwickler zu verstehen, der wäßrige Lösungen von Salzen und Netzmitteln und weniger als ca. 10 Gew.-% an organischen Lösemitteln enthält. Vorzugsweise beträgt der Gehalt an organischen Lösemitteln im Entwickler höchstens 5%, insbesondere höchstens 2% und am besten 0%.

Zur Herstellung des lichtempfindlichen Aufzeichnungsmaterials wird in einem ersten Schritt eine Trägerplatte aus Aluminium oder einer Aluminiumlegierung, die gegebenenfalls nach den üblichen bekannten Aufrauh- und/oder Ätz- und/oder anodischen Oxidationsverfahren vorbehandelt und gegebenenfalls noch mit einem zur Bildung einer hydrophilierenden Oberfläche auf Flachdruckplatten geeigneten Mittel, z. B. Polyvinylphosphonsäure oder Natriumsilikat, behandelt worden ist, mit dem erfindungsgemäßen Gemisch beschichtet.

Mit Hilfe einer Strahlungsquelle wird das lichtempfindliche Material dann durch eine Maske oder eine Transparentvorlage belichtet und in einer anschließenden Entwicklung der nicht belichtete Anteil der lichtempfindlichen Schicht von der belichteten Platte entfernt.

Das lichtempfindliche Gemisch wird gewöhnlich in einem mit allen Bestandteilen verträglichen Lösemittel hergestellt. Es wird dann auf den Träger aufgebracht und das Lösemittel durch Trocknen aus der Beschichtung vertrieben. Das Gemisch kann ferner andere übliche Bestandteile, z. B. Farbmittel, Säuren als Stabilisatoren sowie Belichtungsindikatoren, enthalten.

Die für die Herstellung der lichtempfindlichen Gemische geeigneten Diazoniumverbindungen lassen sich durch die generelle Struktur $A{-}N_2X^+X^-$ kennzeichnen, wobei A ein aromatischer oder heterocyclischer Rest und X das Anion einer Säure ist.

Geeignete lichtempfindliche Diazoniumsalz-Polykondensationsprodukte sind höhermolekulare Substanzen, die z. B. durch Kondensation bestimmter aromatischer Diazoniumsalze mit aktiven Carbonylverbindungen, wie Formaldehyd, in einem sauren Kondensationsmedium erhalten werden, so wie sie aus den US-A-2 063 631 und US-A-2 667 415 bekannt sind. Eine bevorzugte Klasse von Diazoniumsalz-Kondensationsprodukten ist in der US-A-3 849 392 beschrieben.

Von den in dieser Druckschrift beschriebenen Verbindungen werden die Diazoniumsalz-Polykondensationsprodukte mit wiederkehrenden Einheiten $A{-}N_2X$ und B bevorzugt, die durch zweibindige, von einer kondensationsfähigen Carbonylverbindung abgeleitete Zwischenglieder verbunden sind, wobei die Einheiten $A{-}N_2X$ sich aus Verbindungen der allgemeinen Formel

$$(R^1{-}R^3{-})_P R^2{-}N_2X$$

ableiten und wobei

X das Anion der Diazoniumverbindung,

$P_1$ eine ganze Zahl von 1 bis 3,

R einen carbocyclischen oder heterocyclischen aromatischen Rest mit mindestens einer kondensationsfähigen Position,

$R^2$ eine Arylengruppen der Benzol- oder Naphthalinreihe,

$R^3$ eine Einfachbindung oder eine der Gruppen:

$-(CH_2)_q{-}NR^4{-}$

$-O{-}(CH_2)_r{-}NR^4{-}$,

$-S{-}(CH_2)_r{-}NR^4{-}$,

$-S{-}CH_2{-}CO{-}NR^4{-}$,

$-O{-}R^5{-}O{-}$,

$-O-$,

$-S-$ oder

$-CO{-}NR^4{-}$

bedeuten, worin

q eine Zahl von 0 bis 5,

r eine Zahl von 2 bis 5,

$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und

$R^5$ eine Arylengruppe mit 6 bis 12 C-Atomen ist, und

B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeuten.

Ganz besonders bevorzugt wird als Diazoniumsalz das Polykondensationsprodukt aus 3-Methoxy-diphenylamin-4-diazonium-sulfat und 4,4'-Bis-methoxymethyl-diphenylether, ausgefällt als Mesitylensulfonat, verwendet.

Das für die praktische Durchführung dieser Erfindung geeignete Polyvinylacetat hat ein mittleres Molekulargewicht im Bereich von etwa 100 000 bis 800 000.

Insbesondere beträgt das mittlere Molekulargewicht maximal etwa 700 000. Am vorteilhaftesten liegt das mittlere Molekulargewicht im Bereich von etwa 100 000 bis 400 000.

Das Styrol/Maleinsäurepartialester-Copolymere entspricht bevorzugt der allgemeinen Formel:

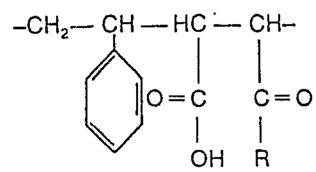

wobei R der Rest eines niederen aliphatischen Alkohols mit 1 bis etwa 5 Kohlenstoffatomen ist. Das Copolymere ist also bevorzugt ein Maleinsäurehalbester-Copolymeres. Eine Styroleinheit erscheint vorzugsweise immer als Endglied der Copolymerenkette. Das Verhältnis Styrol : Maleinsäurehalbester im Copolymeren beträgt dann 1 : <1.

Das mittlere Molekulargewicht des Copolymeren beträgt höchstens 50 000 und liegt vorzugsweise unter 50 000.

Das Copolymere hat vorzugsweise ein mittleres Molekulargewicht von etwa 10 000 bis 50 000. Ein erfindungsgemäß besonders bevorzugtes Copoly-

meres ist ®Scripset 540 (Hersteller Monsanto) mit einem ungefähren mittleren Molekulargewicht von 20 000.

Erfindungsgemäß sind zum Beispiel die folgenden Säuren als Stabilisatoren geeignet: Phosphorsäure, Citronensäure, Weinsäure und p-Toluolsulfonsäure.

Als Belichtungsindikatoren eignen sich z. B. p-Phenylazodiphenylamin, die Farbstoffe Calcocin, Fuchsin, Kristallviolett und Methylenblau.

In dem lichtempfindlichen Kopiermaterial nach der Erfindung können als Farbmittel z. B. Farbstoffe, wie Acetosolfeuerrot 3 GLS, Sandolan-Eosin E-G, Acetosolgrün BLS, Genacrylblau 3 G, Sandolan-Cyanin N-6B, Sandoplastblau R, «Atlantic Alizarin Milling Blue FFR 200», Neozaponfeuerrot BL, Erythrosin, Methylenblau laD Extra, Viktoriareinblau FGA und Pigmente, wie Grüngoldpigment und Sonnenechtviolett, verwendet werden.

Der Anteil des Diazoniumsalzes in der Beschichtungslösung beträgt vorzugsweise etwa 20 bis 50 Gew.-%, bezogen auf die festen, d. h. die nicht flüchtigen Bestandteile. Vorteilhaft liegt sein Anteil bei etwa 25 bis 45 Gew.-% und insbesondere bei etwa 30 bis 40 Gew.-%.

Der Gehalt an Polyvinylacetat in der Beschichtungslösung beträgt vorzugsweise etwa 8 bis 33 Gew.-%, bezogen auf die festen Bestandteile; vorteilhafter beträgt der Gehalt etwa 12 bis 28 Gew.-%, insbesondere etwa 18 bis 23 Gew.-%.

Der Anteil des Styrol/Maleinsäurepartialester-Copolymeren in der Beschichtungslösung, bezogen auf die festen Bestandteile, ist wie folgt: Vorzugsweise etwa 25 bis 55 Gew.-%, vorteilhafter etwa 32 bis 48 Gew.-% und insbesondere etwa 37 bis 43 Gew.-%.

Die gegebenenfalls verwendete Säure ist vorzugsweise in einer Menge von etwa 1,5 bis 4,5 Gew.-%, bezogen auf die festen Bestandteile, vorteilhafter in einer Menge von 2,0 bis 40,0 Gew.-% und insbesondere in einer Menge von etwa 2,5 bis 3,5 Gew.-% anwesend.

Der gegebenenfalls verwendete Belichtungsindikator ist in folgenden Anteilen in der Beschichtungslösung anwesend: vorzugsweise etwa 0,05 bis 0,35 Gew.-%, vorteilhafter etwa 0,10 bis 0,30 Gew.-% und insbesondere etwa 0,15 bis 0,25 Gew.-%, jeweils bezogen auf die festen Bestandteile.

Falls ein Farbmittel, d. h. ein Farbstoff, Farbpigment oder dgl., verwendet wird, so ist dieses vorzugsweise in einem Anteil von etwa 0,25 bis 0,55 Gew.-%, vorteilhafter von etwa 0,30 bis 0,50 Gew.-% und insbesondere von etwa 0,35 bis 0,45 Gew.-%, jeweils bezogen auf die festen Bestandteile, in der Beschichtungslösung enthalten.

Geeignete Lösemittel, in denen die Bestandteile der erfindungsgemäßen Beschichtungsmasse miteinander vermischt werden können, sind z. B. Ethylenglykolether, Butyrolacton, Alkohole, z. B. Ethanol und n-Propanol; und Ketone, z. B. Methylethylketon. Im allgemeinen werden diese Lösemittel nach dem Aufbringen der Beschichtungsmasse auf einen geeigneten Träger aus der Beschichtung vertrieben; es kann jedoch ein geringfügiger Rest an Lösemittel in der Beschichtung zurückbleiben.

Zu den geeigneten Trägermaterialien, die für die Herstellung des erfindungsgemäßen lichtempfindlichen Aufzeichnungsmaterials verwendet werden können, zählen u. a. transparente Folien, Aluminiumlegierungen, Silizium und ähnliche bekannte Materialien.

Bei der Herstellung von Flachdruckplatten wird ein Aluminiumträger zunächst vorzugsweise nach bewährten Verfahren aufgerauht, z. B. durch Drahtbürsten, durch Bürsten mit einer Aufschlämmung von feinteiligen Stoffen oder auf elektrochemischem Wege, z. B. in einem Salzsäureelektrolyten. Die aufgerauhte Platte kann dann auf bekannte Weise, zum Beispiel in Schwefel- oder Phosphorsäure, anodisch oxidiert werden. Nach Verfahren, die dem Fachmann bekannt sind, wird die aufgerauhte und anodisch oxidierte Oberfläche danach gegebenenfalls hydrophiliert, zum Beispiel durch eine Behandlung mit Polyvinylphosphonsäure, Natriumsilikat oder dergl. Die so vorbereitete Platte wird anschließend mit dem erfindungsgemäßen lichthärtbaren Gemisch beschichtet, getrocknet, durch eine entsprechende Maske mit aktinischer Strahlung belichtet und mit einem wäßrigen Entwickler entwickelt.

Als Entwickler für das erfindungsgemäße lichtempfindliche Aufzeichnungsmaterial eignet sich beispielsweise eine wäßrig-alkalische Lösung mit einem Gehalt an:

a) einem Natrium-, Kalium- oder Lithiumsalz des Monooctyl-, Monodecyl- oder Monododecylsulfats,

b) einem Natrium-, Lithium-, Kalium- oder Ammoniummetasilikat,

c) einem Lithium-, Kalium-, Natrium- oder Ammoniumborat,

d) einer aliphatischen Dicarbonsäure mit 2 bis 6 Kohlenstoffatomen oder deren Natrium-, Kalium- oder Ammoniumsalz und/oder

e) Di- und/oder Trinatrium- oder -kaliumphosphat.

Die Erfindung wird anhand der folgenden Beispiele näher erläutert:

Beispiel 1

Es wird eine Beschichtungslösung der folgenden Zusammensetzung hergestellt:

| | |
|---|---|
| 0,447 g | Phosphorsäure (85%-ig), |
| 2,790 g | Polyvinylacetat (Molgewicht um 400 000), |
| 5,581 g | Styrol/Maleinsäurehalbester-Copolymeres (Scripset 540; Molekulargewicht 20 000), |
| 0,030 g | p-Phenylazo-diphenylamin, |
| 0,056 g | Acetosolfeuerrot 3 GLS (C. I. Solvent Red 124), |
| 5,023 g | eines Diazoniumsalz-Polykondensationsprodukts aus 1 mol 3-Methoxy-diphenylamin-4-diazoniumsalz und 1 mol 4,4'-Bis-methoxymethyl-diphenylether, ausgefällt als Mesitylensulfonat. |

Die obengenannten Bestandteile werden unter kräftigem Rühren nacheinander in 450 g Ethylenglykolmonomethylether gegeben. Nach Auflösen aller Bestandteile wird die Lösung filtriert und mit 70 U/min auf eine durch Bürsten mit einer Schleifmittelsuspension aufgerauhte und hydrophilierte Aluminiumoberfläche aufgeschleudert. Nach dem Trocknen wird die Platte in einem Berkey/Ascor-Belichtungsgerät durch eine Negativvorlage mit 300 mJ/cm$^2$ belichtet. Die belichtete Platte wird mit einem wäßrig-alkalischen Entwickler der folgenden Zusammensetzung entwickelt:

| | |
|---|---|
| $H_2O$ | 91,7% |
| Natriumoctylsulfat | 2,5% |
| Natriummetasilikat | 0,1% |
| Dinatriumhydrogenphosphat | 1,5% |
| Trinatriumphosphat | 1,5% |
| Kaliumoxalat | 1,7% |
| Kaliumtetraborat | 1,0% |

Dabei werden die nichtbelichteten Teile der Beschichtung entfernt, und die belichteten Teile verbleiben als Bild auf der Platte. Die Platte wird mit einer wäßrigen Lösung von 10% hydrolysierter Tapiocastärke und 0,5% Phosphorsäure abgespült. Die so hergestellte Platte wird in eine Bogenoffsetmaschine eingespannt und liefert unter normalen Druckbedingungen 30 000 Kopien in guter Qualität.

Beispiel 2

Es wird nach den Angaben von Beispiel 1 gearbeitet, jedoch wird in diesem Fall das Polyvinylacetat weggelassen. Die Bildstellen werden hier durch den Entwickler angegriffen, und es wird infolgedessen eine verkürzte Wiedergabe des Stufenkeils, eine Zuspitzung der Rasterpunkte und ein Verlust an Schichtgewicht festgestellt.

Beispiel 3

Es wird nach den Angaben von Beispiel 1 gearbeitet, allerdings ohne das Polystyrol/Maleinsäurehalbester-Copolymere. Hier lagern sich erhebliche Mengen der von den Nichtbildstellen abgelösten Beschichtungsmasse wieder auf den Bildstellen der Platte ab. Mit dieser Platte konnte nicht mehr mit guter Qualität gedruckt werden.

Beispiel 4

Es wird nach den Angaben von Beispiel 1 gearbeitet, aber anstelle des dort verwendeten Polyvinylacetats wird ein Polyvinylacetat mit einem Molekulargewicht von 100 000 verwendet. Die Ergebnisse sind mit Beispiel 1 vergleichbar.

Beispiel 5

Es wird nach den Angaben von Beispiel 1 gearbeitet, jedoch wird hier die beschriebene Beschichtungslösung auf eine wie dort aufgerauhte, dann anodisch oxidierte und hydrophilierte Aluminiumoberfläche aufgebracht. Die fertige Platte wird in eine Bogenoffsetmaschine eingespannt und liefert unter normalen Druckbedingungen 60 000 Kopien in guter Qualität.

Beispiel 6

Es wird nach den Angaben von Beispiel 1 gearbeitet, in diesem Fall wird die beschriebene Beschichtungslösung aber auf eine elektrochemisch aufgerauhte und hydrophilierte Aluminiumoberfläche aufgebracht. Die so hergestellte Platte wird in eine Bogenoffsetmaschine eingespannt und liefert unter normalen Druckbedingungen 300 000 Kopien in guter Qualität.

**Patentansprüche**

1. Verfahren zur Herstellung von Flachdruckplatten, bei dem man ein lichtempfindliches Aufzeichnungsmaterial, dessen lichtempfindliche Schicht als wesentliche Bestandteile

a) ein Diazoniumsalz-Polykondensationsprodukt,

b) ein Styrol/Maleinsäuremonoalkylester-Copolymerisat, in dem die Akylgruppe 1 bis 5 Kohlenstoffatome hat und das ein mittleres Molekulargewicht von nicht mehr als 50 000 aufweist, und

c) ein Vinylacetatpolymerisat mit einem mittleren Molekulargewicht von 100 000 bis 800 000 enthält,

bildmäßig belichtet und durch Auswaschen der unbelichteten Schichtbereiche entwickelt, dadurch gekennzeichnet, daß man als Entwickler eine wäßrig-alkalische Lösung einsetzt, die ein Natrium-, Kalium- oder Lithiumsalz des Monooctyl-, Monodecyl- oder Monododecylsulfats, ein Natrium-, Lithium-, Kalium- oder Ammoniumborat oder -metasilikat, eine aliphatische Dicarbonsäure mit 2 bis 6 Kohlenstoffatomen oder deren Natrium-, Kalium- oder Ammoniumsalz, ein Di- oder Trinatrium- oder ein Di- oder Trikaliumphosphat enthält.

2. Verfahren nach Anspruch 1, dadurch gekennzeichnet, daß das Vinylacetatpolymerisat Polyvinylacetat ist.

3. Verfahren nach Anspruch 1, dadurch gekennzeichnet, daß das Styrol/Maleinsäuremonoalkylester-Copolymerisat endständige Styroleinheiten aufweist.

4. Verfahren nach Anspruch 1, dadurch gekennzeichnet, daß das Diazoniumsalz-Polykondensationsprodukt wiederkehrende Einheiten $A-N_2X$ und B enthält, die durch zweibindige, von einer kondensationsfähigen Carbonylverbindung abgeleitete Zwischenglieder verbunden sind, wobei die Einheiten $A-N_2X$ sich aus Verbindungen der allgemeinen Formel

$$(R^1-R^3-)_pR^2-N_2X$$

ableiten und wobei

X das Anion der Diazoniumverbindung,

p eine ganze Zahl von 1 bis 3,

$R^1$ einen carbocyclischen oder heterocyclischen aromatischen Rest mit mindestens einer kondensationsfähigen Position,

$R^2$ eine Arylengruppe der Benzol- oder Naphthalinreihe,

$R^3$ eine Einfachbindung oder eine der Gruppen:

$-(CH_2)_q-NR^4-$

$-O-(CH_2)_r-NR^4-$,

$-S-(CH_2)_r-NR^4-$,

$-S-CH_2-CO-NR^4-$,

$-O-R^5-O-$,

–O–,
–S– oder
–CO–$NR^4$–
bedeuten, worin

q eine Zahl von 0 bis 5,

r eine Zahl von 2 bis 5,

$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und

$R^5$ eine Arylengruppe mit 6 bis 12 C-Atomen ist, und

B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeuten.

5. Verfahren nach Anspruch 1, dadurch gekennzeichnet, daß die lichtempfindliche Schicht 20 bis 50 Gew.-% Diazoniumsalz-Polykondensationsprodukt, 8 bis 33 Gew.-% Vinylacetatpolymerisat und 25 bis 55 Gew.-% Styrol/Maleinsäuremonoalkylester-Copolymerisat enthält.

## Claims

1. Process for the production of planographic printing plates in which a photosensitive recording material whose photosensitive layer contains as essential components

a) a diazonium salt polycondensation product,

b) a styrene/monoalkyl maleate copolymer in which the alkyl group has 1 to 5 carbon atoms and which has an average molecular weight of not more than 50 000 and

c) a vinyl acetate polymer having an average molecular weight of from 100 000 to 800 000,

is exposed imagewise and developed by washing out the unexposed areas of the layer, characterized in that, as developer, an aqueous alkaline solution is employed which contains a sodium, potassium or lithium salt of monooctyl-, monodecyl- or monododecylsulphate, a sodium, lithium potassium, or ammonium borate or metasilicate, an aliphatic dicarboxylic acid having 2 to 6 carbon atoms or the sodium, potassium or ammonium salt thereof, or a di- or tri-sodium or di- or tripotassium phosphate.

2. Process according to Claim 1, characterized in that the vinyl acetate polymer is polyvinyl acetate.

3. Process according to Claim 1, characterized in that the styrene/monoalkyl maleate copolymer contains terminal styrene units.

4. Process according to Claim 1, characterized in that the diazonium salt polycondensation product contains recurring units A–$N_2X$ and B which are connected by spacer groups derived from a condensation-capable carbonyl compound, where the units A–$N_2X$ are derived from compounds of the general formula

$$(R^1–R^3–)_pR^2–N_2X$$

and where

X denotes the anion of the diazonium compound,

p denotes an integer from 1 to 3,

$R^1$ denotes a carbocyclic or heterocyclic aromatic radical having at least one condensation-capable position,

$R^2$ denotes an arylene group of the benzene or naphthalene series,

$R^3$ denotes a single bond or one of the groups:

–$(CH_2)_q$–$NR^4$–
–O–$(CH_2)_r$–$NR^4$–,
–S–$(CH_2)_r$–$NR^4$–,
–S–$CH_2$–CO–$NR^4$–,
–O–$R^5$–O–,
–O–,
–S– or
–CO–$NR^4$–
in which

q is a number from 0 to 5,

r ist a number from 2 to 5,

$R^4$ is hydrogen, an alkyl group having 1 to 5 C atoms, an aralkyl group having 7 to 12 C atoms or an aryl group having 6 to 12 C atoms, and

$R^5$ is an arylene group having 6 to 12 C atoms, and

B denotes the diazonium group-free radical of an aromatic amine, phenol, thiophenol, phenol ether, aromatic thioether, aromatic hydrocarbon, aromatic heterocyclic compound or organic acid amide.

5. Process according to Claim 1, characterized in that the photosensitive layer contains 20 to 50% by weight of diazonium salt polycondensation product, 8 to 33% by weight of vinyl acetate polymer and 25 to 55% by weight of styrene/monoalkyl maleate copolymer.

## Revendications

1. Procédé de préparation de plaques d'impression planographique dans lequel on expose selon une image un matériau d'enregistrement photosensible dont la couche photosensible contient comme constituants essentiels:

a) un produit de polycondensation de sel de diazonium,

b) un copolymère styrène-ester monoalkylique de l'acide maléique, dans lequel le groupe alkyle a de 1 à 5 atomes de carbone et qui présente un poids moléculaire moyen ne dépassant pas 50 000 et

c) un polymère d'acétate de vinyle ayant un poids moléculaire moyen de 100 000 à 800 000,

et on le développe en éliminant par lavage les régions non exposées de la couche, caractérisé en ce que l'on emploie comme développateur une solution alcaline aqueuse qui contient un sel de sodium, de potassium ou de lithium du sulfate monooctylique, monodécylique ou monododécylique, un borate ou un métasilicate de sodium, de lithium, de potassium ou d'ammonium, un diacide carboxylique aliphatique ayant de 2 à 6 atomes de carbone ou le sel de sodium, de potassium ou

d'ammonium de celui-ci, un phosphate di- ou trisodique ou un phosphate di- ou tripotassique.

2. Procédé selon la revendication 1, caractérisé en ce que le polymère d'acétate de vinyle est de l'acétate de polyvinyle.

3. Procédé selon la revendication 1, caractérisé en ce que le copolymère styrène-ester monoalkylique de l'acide maléique présente des motifs styrène terminaux.

4. Procédé selon la revendication 1, caractérisé en ce que le produit de polycondensation de sel de diazonium comporte des motifs répétitifs $A-N_2X$ et B qui sont reliés par des membres intermédiaires bivalents dérivés d'un composé carbonylé apte à la condensation, les motifs $A-N_2X$ étant dérivés de composés de formule générale:

$$(R^1-R^3-)_pR^2-N_2X$$

et

X représentant l'anion du composé de diazonium,

p un nombre entier de 1 à 3,

$R^1$ un radical aromatique carbocyclique ou hétérocyclique ayant au moins une position apte à la condensation,

$R^2$ un groupe arylène de la série du benzène ou du naphtalène,

$R^3$ une liaison simple ou l'un des groupes:

$-(CH_2)_q-NR^4-$,
$-O-(CH_2)_r-NR^4-$,
$-S-(CH_2)_r-NR^4-$,
$-S-CH_2-CO-NR^4-$,
$-O-R^5-O-$,
$-O-$,
$-S-$, ou
$-CO-NR^4-$

dans lesquels:

q est un nombre de 0 à 5,

r un nombre de 2 à 5,

$R^4$ un atome d'hydrogène, un groupe alkyle ayant de 1 à 5 atomes de carbone, un groupe aralkyle ayant de 7 à 12 atomes de carbone ou un groupe aryle ayant de 6 à 12 atomes de carbone, et

$R^5$ un groupe arylène ayant de 6 à 12 atomes de carbone, et

B représente le radical exempt de groupe diazonium d'une amine aromatique, d'un phénol, d'un thiophénol, d'un phénoléther, d'un thioéther aromatique, d'un hydrocarbure aromatique, d'un composé hétérocyclique aromatique ou d'un amide d'acide organique.

5. Procédé selon la revendication 1, caractérisé en ce que la couche photosensible contient de 20 à 50% en poids de produit de polycondensation de sel de diazonium, de 8 à 33% en poids de polymère d'acétate de vinyle et 25 à 55% en poids de copolymère styrène-ester monoalkylique de l'acide maléique.